# EUROPEAN PATENT APPLICATION

(11) **EP 1 317 062 A2**
(43) Date of publication of application: **04.06.2003**
(21) Application number: 02257920.5
(22) Date of filing: 15.11.2002
(51) Int. Cl.: H03F 1/02, H04B 7/005, H03G 3/30, H04B 1/44

(54) **Power supply control of cascaded amplifiers in a transmission circuit**

(30) Priority: 16.11.2001 JP 2001351556; 16.11.2001 JP 2001351557
(71) Applicant: Alps Electric Co., Ltd., Tokyo 145-8501 (JP)
(72) Inventor: Takeda, Shuichi, c/o Alps Electric Co., Ltd., Ota-ku, Tokyo (JP)
(74) Representative: Kensett, John Hinton

(57) **Abstract**

Transmission/reception switch means (3) includes first opening/closing means (3a) for supplying power supply voltage to amplifiers except for the final stage amplifier, second opening/closing means (3b) for supplying power supply voltage to the final stage amplifier, control means (3e) for controlling the opening/closingoperation of the first and second opening/closing, and third opening/closing means (3f) interposed between the control means and the second opening/closing means. The third switch means can be open/closed, so that only the power supply voltage supplied to the final stage amplifier in the power amplifier can be interrupted by the transmission/reception switch means in a transmission mode.

## Description

### BACKGROUND OF THE INVENTION

### 1. Field of the Invention

The present invention relates to a transmission circuit for a transmitter/receiver for use in a cordless telephone set.

### 2. Description of the Prior Art

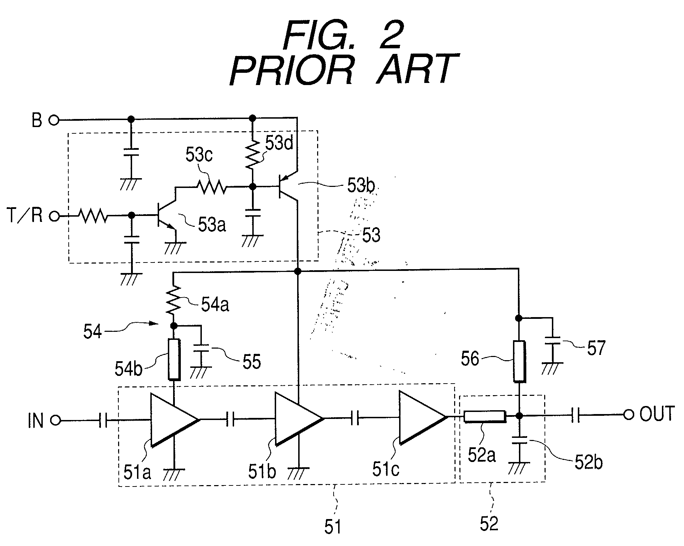

A conventional transmission circuit will be described in conjunction with Fig. 2. A power amplifier 51 includes three stages of amplifiers 51a, 51b, and 51c in a cascade connection, the first stage amplifier 51a and the second stage amplifier 51b each have a gain of 14 dB, and the final stage, third stage amplifier 51c has a gain of 14 dB. The output end of the third stage amplifier 51c is connected with an impedance matching circuit 52 including a strip line 52a and a capacitor 52b. The power amplifier 51 is connected through the impedance matching circuit 52 with an antenna that is not shown. The first stage amplifier 51a is provided with a transmission signal about at 0 dBm as an input.

The power amplifier 51 is supplied with power supply voltage from transmission/reception switch means 53. The transmission/reception switch means 53 includes an NPN transistor 53a and a PNP transistor 53b. The NPN transistor 53a has its emitter grounded and its collector connected to the base of the PNP transistor 53b through a resistor 53c. The PNP transistor 53b has its emitter connected to a power supply B and its base connected to the power supply B through a resistor 53d. The collector that supplies the power amplifier 51 with power supply voltage is connected with the power supply end of the first stage amplifier 51a through a series feeding circuit 54 including a resistor 54a and a strip line 54b. The strip line 54b has a length substantially 1/4 of the wavelength of the transmission signal. The connection node of the resistor 54a and the strip line 54b is grounded through a grounding capacitor 55 to deal with high frequencies.

The PNP transistor 53b has its collector directly connected to the power supply end of the second stage amplifier 51b, and also to the output end of the impedance matching circuit 52 through a feeding strip line 56. It is also connected to the output end of the third stage amplifier 51c through a strip line 52a. The output end also serves as a power supply end. The feeding strip line 56 also has a length substantially 1/4 of the wavelength of the transmission signal. The connection node of the collector of the PNP transistor 53b and the feeding strip line 56 is grounded through a grounding capacitor 57 to deal with high frequencies.

A transmission/reception switch signal T/R to turn on/off the NPN transistor 53a is input to the base of the transistor. In a transmission mode, the transmission/reception switch signal T/R attains a high level. This turns on the NPN transistor 53a and the PNP transistor 53b, so that power supply voltage is supplied to the amplifiers 51a, 51b, and 51c.

The transmission signal input to the first stage amplifier 51a is amplified by the amplifiers 51a, 51b, and 51c, and output to the antenna through the impedance matching circuit 52. The output power is about 28 dBm. At the time, as the feeding strip line 56 is grounded through the capacitor 57 provided on the power supply side to deal with high frequencies, the impedance in view of the power supply side from the output end of the impedance matching circuit 52 is high, so that the transmission signal output from the third stage amplifier 51c is not leaked to the power supply side through the feeding strip line 56.

Meanwhile, in a reception mode, the transmission/reception switch signal T/R attains a low level. This turns off the NPN transistor 53a and the PNP transistor 53b, so that the power supply voltage supplied to the amplifiers 51a, 51b, and 51c is interrupted.

The power output at the conventional transmission circuit is substantially fixed at a level of 28 dBm, and therefore more than necessary power is output for example when a base unit and a sub unit transmit/receive a signal in close proximity to each other. Therefore, in the power amplifier, especially in the final stage amplifier, excess current is wasted. In addition, since the output power is so large that other electronic equipment used at home could be interfered with.

Also in the conventional transmission circuit, when the feeding strip line that supplies power supply voltage to the final stage amplifier is as long as 1/4 of the wavelength of a transmission signal, the transmission signal is not leaked onto the feeding strip line. Meanwhile, if the length varies, the impedance in view of the feeding strip line is lowered and the transmission signal is leaked. As a result, not only the transmission power is lowered but also current by the leaked signal is passed to a position where the grounding capacitor is grounded. At the time, when another circuit is formed near the grounding position, the ground potential of the circuit fluctuates, which makes the operation of the circuit unstable. Particularly when a PLL circuit is the other circuit, the oscillation frequency fluctuates.

### SUMMARY OF THE INVENTION

It is therefore an object of the present invention to allow the level of the transmission signal to be switched by interrupting power supply voltage supplied to the power amplifier and power consumption to be reduced, and to prevent the interference with other electronic equipment, etc.

Another object of the invention is to restrain transmission signal current coming onto a feeding strip line that supplies power supply voltage to the output end of a power amplifier when the length of the feeding strip line varies from a length substantially 1/4 of the wavelength of the transmission signal.

In order to solve the above problems, according to the invention, there is provided a transmission circuit comprising a power amplifier including a plurality of amplifiers in a cascade connection, and transmission/reception switch means for supplying the power amplifier with power supply voltage in a transmission mode, and interrupting the power supply voltage supplied to the power amplifier in a reception mode. The transmission/reception switch means can interrupt only the power supply voltage supplied to the final stage amplifier in the power amplifier in the transmission mode.

The transmission/reception switch means may include first opening/closing means for supplying an amplifier other than the final stage amplifier with the power supply voltage, second opening/closing means for supplying the final stage amplifier with the power supply voltage, control means for controlling the opening/closing operation of the first and second opening/closing means, and third opening/closing means interposed between the control means and the second opening/closing means, and the third switch means can be opened/closed.

The first opening/closing means may include a first PNP transistor having its emitter connected to the power supply for supplying voltage from its collector to an amplifier other than the final stage amplifier, the second opening/closing means includes a second PNP transistor having its emitter connected to the power supply for supplying voltage from its collector to the final stage amplifier, the control means includes an NPN transistor having its emitter grounded and its collector connected to the power supply and the base of the first PNP transistor through a resistor, the third opening/closing means includes a single gate FET having its source connected to the collector of the NPN transistor and its drain connected to the power supply and the base of the second PNP transistor through a resistor, a transmission/reception switch signal to turn on/off the NPN transistor is input to the base of the NPN transistor, and a transmission power switch signal to turn on/off the single gate FET is input to the gate of the single gate FET.

In a second aspect there is provided a transmission circuit, comprising a power amplifier having an output end serving as a power supply end, and a feeding strip line substantially as long as 1/4 of the wavelength of a transmission signal that supplies the power supply end with voltage from a power supply. The power supply side end in the feeding strip line is grounded through a terminating circuit including a grounding capacitor that attains a low impedance at the frequency of a transmission signal and a resistor connected in series to the grounding capacitor, so that the resistance value of the resistor is set to a value that can be ignored with respect to the characteristic impedance of the feeding strip line.

The resistance value of the resistor may be in the range from 2 Q to 10 Q.

An embodiment of the present invention will now be described, by way of example only, with reference to the accompanying diagrammatic drawings, in which:
Fig. 1 is a circuit diagram of a transmission circuit according to the invention; and
Fig. 2 is a circuit diagram of a conventional transmission circuit.

### DESCRIPTION OF THE PREFERRED EMBODIMENTS

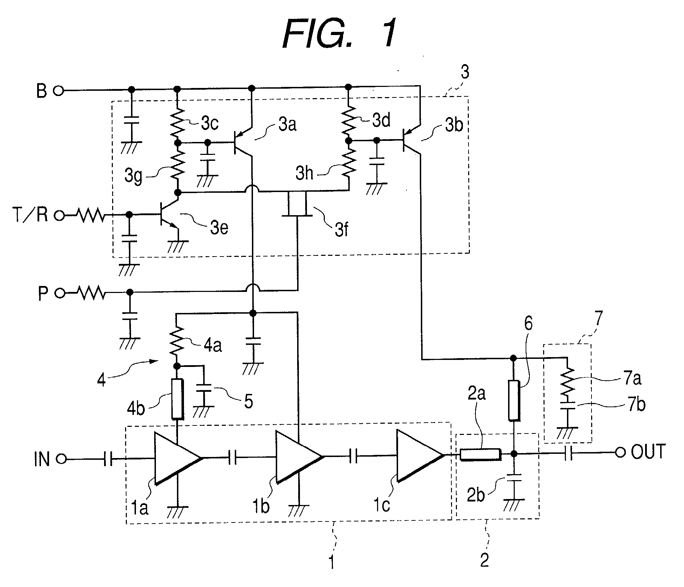

A transmission circuit according to the invention will be described in conjunction with Fig. 1. A power amplifier 1 includes three stages of amplifiers 1a, 1b, and 1c in a cascade connection, and the first stage amplifier 1a and the second stage amplifier 1b each have a gain of about 7 dB, while the final stage, third stage amplifier 1c has a gain of about 14 dB. A transmission signal at a level of about 0 dBm is input to the first stage amplifier 1a. The output end of the third stage amplifier 1c is connected with an impedance matching circuit 2 including a strip line 2a and a capacitor 2b. The power amplifier 1 is connected through the impedance matching circuit 2 with an antenna that is not shown.

The power amplifier 1 is supplied with power supply voltage from transmission/reception switch means 3. The transmission/reception switch means 3 includes a first PNP transistor 3a as first opening/closing means, and a second PNP transistor 3b as second opening/closing means. The first PNP transistor 3a has its emitter connected to a power supply B and its base connected to the power supply B through a resistor 3c.

The second PNP transistor 3b has its emitter connected to the power supply B and its base connected to the power supply B through a resistor 3d.

The transmission/reception switch means 3 further includes an NPN transistor 3e serving as control means to carry out control to turn on/off both the first and second PNP transistors 3a and 3b, and a single gate FET 3f serving as third opening/closing means. The NPN transistor 3e has its emitter grounded and its collector connected to the base of the first PNP transistor 3a through a resistor 3g. The single gate FET 3f has its source connected to the collector of the NPN transistor 3e, and its drain connected to the base of the second PNP transistor 3b through a resistor 3h.

A transmission/reception switch signal T/R to turn on/off the NPN transistor 3e to switch between the transmission and reception modes is input to the base of the transistor. A transmission power switch signal P to turn on/off the single gate FET 3f is input to the gate of the single gate. The transmission power switch signal P is input from a reception circuit that is not shown. When for example a base unit and a sub unit transmit/receive a signal in close proximity to each other, the received signal level is high. Therefore, the single gate FET is turned off when the level is equal to or higher than a prescribed value.

The first PNP transistor 3a has its collector connected to the power supply end of the first stage amplifier 1a through the series feeding circuit 4 including a resistor 4a and a strip line 4b. The strip line 4b has a length substantially 1/4 of the wavelength of a transmission signal. The connection node of the resistor 4a and the strip line 4b is grounded through a grounding capacitor 5 to deal with high frequencies. The first PNP transistor 3a has its collector directly connected to the power supply end of the second stage amplifier 1b.

The second PNP transistor 3b has its collector connected to the output end of the impedance matching circuit 2 through a feeding strip line 6, from which the output end of the third stage amplifier 1c is supplied with voltage. The output end of the third stage amplifier 1c serves as a power supply end. The feeding strip line 6 also has a length substantially 1/4 of the wavelength of the transmission signal. The connection node of the collector of the second PNP transistor 3b and the feeding strip line 6 (one end on the power supply side) is grounded through a series terminating circuit 7 including a resistor 7a and a grounding capacitor 7b whose high frequency impedance is extremely low. The resistance value of the resistor 7a is set to a value about in the range from 2 Ω to 10 Q that can be ignored with respect to the characteristic impedance of the feeding strip line 6.

In a transmission mode, the transmission/reception switch signal T/R attains a high level. This turns on the NPN transistor 3e and the first PNP transistor 3a. Then, voltage is supplied to the first stage amplifier 3a and the second stage amplifier 3b.

At the time, when the level of a reception signal is not more than a prescribed value, in other words, when the base unit and the sub unit are located far from each other, the transmission power switch signal P attains a high level and the single gate FET 3f is turned on. This turns on the second PNP transistor 3b accordingly. Therefore, the third stage amplifier 3c is supplied with power supply voltage, so that a transmission signal at about 28 dBm is output from the power amplifier 1.

However in the transmission mode, when the level of the reception signal is not less than the prescribed value, the transmission power switch signal P attains a low level, and while the first PNP transistor 3a is still on, the second PNP transistor 3b is turned off. Then, only the voltage supplied to the third amplifier 3c is interrupted. As a result, in the power amplifier 1, the first stage amplifier 1a and the second stage amplifier 1b operate, while the third stage amplifier 1c does not operate. The third amplifier 1c serves as an attenuator for about 14 dBm and therefore the level of the signal at 14 dBm output from the second stage amplifier 1b becomes substantially 0 dBm. Current of about 100 mA (milliamperes) otherwise supplied to the third stage amplifier 1c is saved.

Even when the transmission power is lowered, transmission/reception can sufficiently be carried out in close proximity, and the interference with other electronic equipment, etc. can be eliminated.

Note that when the length of the feeding strip line 6 varies, the transmission signal though only a little leaks onto the feeding strip line 6 from the output end of the impedance matching circuit 2. However, the leakage could be restricted to a small amount by the resistor 7a connected in series to the capacitor 7b.

In the reception mode, the transmission/reception switch signal T/R attains a low level, and the NPN transistor 3f is turned off. This turns off the first PNP transistor 3b and the second PNP transistor 3b is turned off regardless of the on/off state of the single gate FET 3f. Therefore, the power supply voltage supplied to the amplifiers 1a, 1b, and 1c is interrupted.

As in the foregoing, according to the present invention, there are a power amplifier including a plurality of amplifiers in a cascade connection, and transmission/reception switch means for supplying the power amplifier with power supply voltage in a transmission mode, and interrupting the power supply voltage supplied to the power amplifier in a reception mode. The transmission/reception switch means can interrupt only the power supply voltage supplied to the final stage amplifier in the power amplifier in the transmission mode. Therefore, when the power supply to the final stage amplifier is interrupted at the time of transmission to a base station in close proximity, communication with the base station can be maintained with reduced transmission power. Therefore, the power consumption can be reduced, and the interference with other electronic equipment can be eliminated.

Furthermore, the transmission/reception switch means includes first opening/closing means for supplying an amplifier other than the final stage amplifier with the power supply voltage, second opening/closing means for supplying the final stage amplifier with the power supply voltage, control means for controlling the opening/closing operation of the first and second opening/closing means, and third opening/closing means interposed between the control means and the second opening/closing means, and the third switch means can be opened/closed. Therefore, only the power supply voltage supplied to the final stage amplifier can be interrupted.

A transmission/reception switch signal to turn on/off the NPN transistor as the control means is input to the base of the transistor, and a transmission power switch signal to turn on/off the single gate FET is input to the gate of the single gate FET. Therefore, the first and second PNP transistors that feed the amplifiers can be turned on by the NPN transistor when the single gate FET is on, so that only the second PNP transistor that feeds the final stage amplifier can be turned off by the single gate FET in this state.

Furthermore, according to the present invention, there are a power amplifier having an output end serving as a power supply end, and a feeding strip line substantially as long as 1/4 of the wavelength of a transmission signal that supplies the power supply end with voltage from a power supply, and the power supply side end in the feeding strip line is grounded through a terminating circuit including a grounding capacitor that attains a low impedance at the frequency of a transmission signal and a resistor connected in series with the grounding capacitor, so that the resistance value of the resistor is set to a value that can be ignored with respect to the characteristic impedance of the feeding strip line. Therefore, when the length of the feeding strip line varies from substantially the 1/4 length, a transmission signal coming onto the feeding strip line can be restrained. Therefore, potential fluctuations in the grounded position of the terminating circuit can be reduced.

Furthermore, the resistance value of the resistor is set in the range from 2 Ω to 10 Ω. Therefore, the impedance in view of the feeding strip line side can be kept at a high level.

## Claims

1. A transmission circuit, comprising a power amplifier including a plurality of amplifiers in a cascade connection, and transmission/reception switch means for supplying said power amplifier with power supply voltage in a transmission mode, and interrupting said power supply voltage supplied to said power amplifier in a reception mode, said transmission/reception switch means being capable of interrupting only said power supply voltage supplied to the final stage amplifier in said power amplifier in said transmission mode.

2. The transmission circuit according to claim 1, wherein
said transmission/reception switch means comprises first opening/closing means for supplying an amplifier other than the final stage amplifier with said power supply voltage, second opening/closing means for supplying said final stage amplifier with said power supply voltage, control means for controlling the opening/closing operation of said first and second opening/closing means, and third opening/closing means interposed between said control means and said second opening/closing means, and said third switch means can be opened/closed.

3. The transmission circuit according to claim 2, wherein
said first opening/closing means comprises a first PNP transistor having its emitter connected to said power supply for supplying voltage from its collector to an amplifier other than said final stage amplifier, said second opening/closing means comprises a second PNP transistor having its emitter connected to said power supply for supplying voltage from its collector to said final stage amplifier, said control means comprises an NPN transistor having its emitter grounded and its collector connected to said power supply and the base of said first PNP transistor through a resistor, said third opening/closing means comprises a single gate FET having its source connected to the collector of said NPN transistor and its drain connected to said power supply and the base of said second PNP transistor through a resistor, a transmission/reception switch signal to turn on/off said NPN transistor is input to the base of said NPN transistor, and a transmission power switch signal to turn on/off the single gate FET is input to the gate of said single gate FET.

4. A transmission circuit, comprising a power amplifier having an output end serving as a power supply end, and a feeding strip line substantially as long as 1/4 of the wavelength of a transmission signal that supplies said power supply end with voltage from a power supply, said power supply side end in said feeding strip line being grounded through a terminating circuit including a grounding capacitor that attains a low impedance at the frequency of a transmission signal and a resistor connected in series with the grounding capacitor, so that the resistance value of said resistor is set to a value that can be ignored with respect to the characteristic impedance of said feeding strip line.

5. The transmission circuit according to claim 4, wherein
the resistance value of said resistor is set in the range from 2 Ω to 10 Ω.
